# FASCICULE DE BREVET EUROPEEN

(11) **EP 1 644 909 B1**
(45) Date de publication et mention de la délivrance du brevet: **13.04.2011**
(21) Numéro de dépôt: 04767648.1
(22) Date de dépôt: 09.07.2004
(51) Int. Cl.: G09F 27/00

(54) **SYSTEME D'AFFICHAGE DYNAMIQUE DANS UN BOITIER LUMINEUX**
DYNAMISCHES DISPLAY:SYSTEM MIT AUSTAUSCHBAREN ENTFERNBAREN DIGITALEN SCHIRMEN MIT POSTERN IN EINEM RÜCKBELEUCHTETEN GEHÄUSE
DYNAMIC DISPLAY SYSTEM WITH INTERCHANGEABLE REMOVABLE DIGITAL SCREENS WITH POSTERS IN A BACKLIGHTED HOUSING

(30) Priorité: 10.07.2003 FR 0308502
(43) Date de publication de la demande: 12.04.2006
(73) Titulaire: Atuser, 92200 Neuilly sur Seine (FR)
(72) Inventeur: MULLERIS, Jean-Jacques, F-92200 Neuilly sur Seine (FR)
(74) Mandataire: Debay, Yves
(86) Numéro de dépôt international: PCT/FR2004/001817
(87) Numéro de publication internationale: WO 2005/008619

(56) Documents cités:
- DE-A- 19 504 923
- FR-A- 2 810 784
- US-A1- 2001 005 308

## Description

La présente invention se rapporte au domaine de l'affichage d'informations visuelles. L'invention concerne plus particulièrement un système d'affichage permettant une présentation dynamique d'images par l'intermédiaire d'écrans numériques amovibles enfichables dans un boîtier lumineux et interchangeables avec des affiches.

La présentation d'informations visuelles avec des affiches disposées dans des caissons lumineux ou boîtiers appelés couramment Menu Boards s'est très largement répandue, notamment dans les cafés et les grandes chaînes de restauration (snacks, cafétérias, restauration rapide). Il existe ainsi des systèmes d'affichages avec un éclairage disposé à l'arrière du boîtier (rétro-éclairage), intégrant un ou plusieurs supports d'affiche, et éventuellement une zone d'affichage de prix. De tels systèmes offrent donc une présentation statique d'informations visuelles destinées à une clientèle. Les systèmes d'affichages statiques présentent l'inconvénient de nécessiter un renouvellement fréquent des affiches. Dès qu'il faut modifier en intégralité ou en partie les informations affichées, il est nécessaire d'enlever au moins une affiche pour la remplacer par une nouvelle. Cela implique un temps d'immobilisation du système et une manipulation parfois délicate pour des boîtiers généralement placés en hauteur.

Il est connu dans l'art antérieur des panneaux d'affichage à écran plasma dont le volume occupé est important. En effet, le boîtier qui contient ces écrans doit également comporter l'alimentation vidéo de l'écran. Ces écrans présentent par ailleurs le désavantage de dégager de la chaleur, ce qui les soumet à un échauffement. Ils ne peuvent donc être logés dans des espaces confinés tels que du mobilier ou des boîtiers d'affichage à espace réduit et soumis à la chaleur et au rayonnement électromagnétique des tubes d'éclairage.

Il est connu par le brevet FR 2 810 784 du même déposant un moniteur d'affichage vidéo à écran plat installé dans un boîtier d'habillage. Toutefois, ce système n'est pas prévu pour supporter dans un milieu confiné des sources de chaleur et des tubes d'éclairage. Le boîtier d'habillage ne permet pas une présentation d'images par des affiches éclairées lorsque le moniteur est en panne ou non alimenté. En cas d'enlèvement du moniteur du boîtier, aucun affichage lumineux de remplacement n'est permis.

La présente invention a donc pour objet de pallier un ou plusieurs des inconvénients de l'art antérieur en définissant un système d'affichage combinant dans un boîtier lumineux de volume réduit un dispositif porte-affiches pour présenter une ou plusieurs affiches et un écran amovible pour présenter des images animées.

A cet effet, l'invention concerne un système d'affichage dynamique comprenant un boîtier pourvu d'au moins une ouverture frontale et au moins un moyen de support dans le boîtier pour porter au moins un cadre d'affiche amovible, un système d'éclairage réparti dans le boîtier pour fournir un rétro-éclairage des affiches, caractérisé en ce qu'au moins un dispositif amovible d'affichage à commande numérique est prévu en échange d'au moins un cadre d'affiche pour couvrir la ou lesdites ouverture(s) frontale(s), le dispositif amovible incluant une partie dite avant, formée d'un cadre et d'un écran de visualisation plat monté dans le cadre, et une partie arrière de commande et gestion fixée au dos de la partie avant, une interface électrique et mécanique étant prévue sur le dispositif amovible pour établir de manière détachable à la fois une connexion à une source d'alimentation électrique située dans le boîtier et une fixation du dispositif dans un emplacement frontal du boîtier.

L'invention permet ainsi de combiner avantageusement un affichage statique lumineux avec un affichage dynamique.

Selon une autre particularité, l'écran de visualisation est monté dans un cadre de forme et dimensions correspondant à un cadre d'affiche associé, des moyens de fixation solidaires du cadre étant prévus pour maintenir l'écran de visualisation en position frontale.

Selon une autre particularité, le dispositif amovible est dimensionné pour être interchangeable avec un cadre d'affiche présenté à travers ladite ouverture frontale, les moyens de support de cadre d'affiche étant agencés pour s'attacher à des moyens de fixation rapide du dispositif amovible.

Selon une autre particularité, le système d'éclairage comprend au moins un tube fluorescent, la partie arrière du dispositif amovible d'affichage à commande numérique comportant un couvercle de protection contre les rayonnements optiques et électromagnétiques.

Selon une autre particularité de l'invention, la partie arrière du dispositif amovible a un format de dimensions inférieures ou égales au format du cadre de la partie avant, la partie arrière comportant des composants électroniques de gestion et de commande fixés par des moyens d'attache et répartis sur le dos de l'écran de visualisation constituant la partie avant, l'ensemble des composants électroniques étant disposé dans un volume aplati et de forme adaptée délimité par un couvercle de protection dont l'épaisseur est comprise entre 2 et 10 cm.

Selon une autre particularité de l'invention, la partie arrière de l'écran comprend notamment :
- un module d'asservissement vidéo de l'écran plat,
- des moyens de carte graphique avec ou sans carte son,
- une unité de traitement pour la mise en oeuvre de modules logiciels et notamment la gestion de fonctions multimédia de l'écran plat,
- des moyens de mémorisation pour stocker des données représentatives d'images et d'animations audio-vidéo/numériques.

Selon une autre particularité de l'invention, le dispositif amovible comporte des moyens de communication et raccordement à un réseau pour transmettre et recevoir notamment des données de type audio-vidéo numériques par l'intermédiaire d'au moins un canal bidirectionnel.

Selon une autre particularité de l'invention, le dispositif amovible d'affichage à commande numérique comporte des moyens d'évacuation de l'air chauffé par les composants électroniques de gestion et de commande et des composants d'affichage.

Selon une autre particularité, la partie arrière comprend au moins un système de refroidissement localisé pour évacuer la chaleur dégagée par au moins un des composants électroniques de gestion et de commande.

Selon une autre particularité, le dispositif amovible d'affichage comporte une entrée de ventilation munie d'un système de filtration pour retenir les vapeurs d'huiles, corps gras et autres particules (fumée, etc.).

Selon une autre particularité, l'emplacement frontal du boîtier a un volume déterminé pour contenir la partie arrière du dispositif amovible, le couvercle de protection incluant un matériau métallique ayant des propriétés réfléchissantes, le boîtier comprenant un cadre ouvrant à fenêtre amovible ou articulé pour être rabattu sur l'ouverture frontale.

Selon une autre particularité, le dispositif amovible comprend un lecteur de disques supports de données numériques.

Selon une autre particularité, le lecteur est agencé pour être directement accessible par une trappe d'introduction située à l'extérieur de l'emplacement frontal.

Selon une autre particularité, l'écran du dispositif amovible a des dimensions déterminées sensiblement égales aux dimensions de l'ouverture frontale, des moyens d'adaptation étant prévus dans le module d'asservissement vidéo de l'écran pour adapter des données numériques représentatives de vidéo et/ou animations au format de l'écran de visualisation. Selon une autre particularité de l'invention, tes moyens de support de cadre d'affiche consistent en des profilés de maintien disposés en bordure de l'ouverture frontale et aptes à se fixer sur des profilés complémentaires situés à la périphérie respectivement des cadres d'affiches et du dispositif amovible.

Selon une autre particularité, le dispositif amovible d'affichage à commande numérique comprend des moyens d'interface utilisateurs reliés par une connexion physique et/ou à distance à l'unité de traitement pour permettre un contrôle de l'affichage sur l'écran, par utilisation d'un logiciel de programmation stocké dans les moyens de mémorisation.

Selon une autre particularité, le dispositif amovible d'affichage à commande numérique est contrôlé à distance par un serveur de programmation connecté au réseau et disposant de sources d'informations à télé-transmettre, ces sources d'informations incluant notamment des données numériques, ledit serveur de programmation contrôlant un équipement de télémaintenance dudit dispositif.

Selon une autre particularité, le boîtier est sensiblement en forme de trapèze, le boîtier comprenant un bas et un haut horizontaux, le fond du boîtier étant sensiblement vertical, l'ouverture frontale pour le dispositif amovible d'affichage à commande numérique étant inclinée d'un angle compris entre 0 et 30°, l'épaisseur maximale du boîtier restant inférieure à 30 cm et ayant une épaisseur minimale de l'ordre de 10 cm, le système d'éclairage comprenant des moyens d'éclairage répartis sur la hauteur du boîtier.

Selon une autre particularité, des cloisons de canalisation du flux d'air sont prévues dans la partie arrière pour délimiter au moins une zone restreinte d'aération forcée autour de composants électroniques.

Un autre objet de la présente invention est de proposer un dispositif d'affichage à commande numérique pouvant s'insérer de façon amovible dans un caisson ou boîtier de présentation d'affiches.

A cet effet, l'invention concerne un dispositif amovible d'affichage à commande numérique destiné à remplacer au moins un cadre d'affiche dans un caisson ou boîtier du type à rétro-éclairage d'affiche et pourvu d'au moins un moyen de support pour porter au moins un cadre d'affiche amovible et au moins une ouverture frontale avec emplacement frontal de dimensions déterminées, le dispositif étant caractérisé en ce qu'il comporte une interface électrique et mécanique pour établir de manière détachable à la fois une connexion à une source d'alimentation électrique située dans le boîtier et une fixation du dispositif dans l'emplacement frontal, une partie dite avant, formée d'un cadre et d'un écran de visualisation plat monté dans le cadre, et une partie arrière de commande et gestion fixée au dos de la partie avant.

Selon une autre particularité, la partie arrière du dispositif amovible d'affichage à commande numérique comporte un couvercle de protection contre les rayonnements optiques et électromagnétiques.

Selon une autre particularité, la partie arrière du dispositif amovible a un format de dimensions inférieures ou égales au format du cadre de la partie avant, la partie arrière comportant des composants électroniques de gestion et de commande fixés par des moyens d'attache et répartis sur le dos de l'écran de visualisation constituant la partie avant, l'ensemble des composants électroniques étant disposé dans un volume aplati et de forme adaptée délimité par un couvercle de protection dont l'épaisseur est comprise entrer et 10 cm.

Selon une autre particularité, la partie arrière de l'écran comprend notamment :
- un module d'asservissement vidéo de l'écran plat,
- des moyens de carte graphique et carte son,
- une unité de traitement pour la mise en oeuvre de modules logiciels et notamment la gestion de fonctions multimédia de l'écran plat,
- des moyens de mémorisation pour stocker des données représentatives d'images et d'animations audio-vidéo/numériques.

Selon une autre particularité, le dispositif selon l'invention comporte des moyens d'évacuation de l'air chauffé par les composants électroniques de gestion et de commande et des composants d'affichage.

Selon une autre particularité, le dispositif selon l'invention est du type sans ouverture d'aération et comporte un ensemble de ventilation radiale prévu pour brasser l'air chauffé par les composants électroniques de gestion et de commande et assurer une transmission de chaleur à travers le couvercle de protection, ledit couvercle étant à base d'un métal adapté pour transmettre la chaleur par convention et par rayonnement.

Selon une autre particularité, ladite partie arrière est dotée d'au moins un ventilateur disposé de façon tangentielle pour produire une circulation d'air ascendante, au moins une entrée d'aération étant prévue à l'avant du dispositif en dessous de l'écran de visualisation et une sortie d'extraction à l'arrière du dispositif.

L'invention, avec ses caractéristiques et avantages, ressortira plus clairement à la lecture de la description faite en référence aux dessins annexés donnés à titre d'exemples non limitatifs dans lesquels :
- la figure 1 représente un mode de réalisation du système d'affichage selon l'invention,
- la figure 2 représente une vue en perspective d'un exemple de d'agencement de la partie arrière du dispositif amovible d'affichage à commande numérique,
- la figure 3 représente une vue en perspective de la partie avant du dispositif amovible d'affichage à commande numérique,
- la figure 4 représente une vue en perspective d'un mode de réalisation de l'invention avec deux ouvertures frontales, dans lequel est combinée une présentation d'une image fixe sur une affiche et d'images animées sur un écran plat,
- la figure 5a montre une vue en coupe d'un boîtier avec affiche et la figure 5b montre une vue en coupe du même boîtier avec le dispositif d'affichage dynamique en remplacement du cadre d'affiche,
- la figure 5c montre une vue en coupe selon l'axe B-B de la figure 6a d'un système d'affichage selon l'invention dans lequel l'écran de visualisation est disposé parallèlement au fond du caisson,
- les figures 6a et 6b représentent respectivement une vue en perspective et une vue en coupe selon l'axe B-B de la figure 6a d'un dispositif d'affichage amovible dans une variante particulière de l'invention,
- la figure 7 représente une vue de dessus en coupe d'un dispositif d'affichage amovible,
- la figure 8 montre une vue de l'arrière d'un dispositif d'affichage amovible,
- les figures 8a et 8b représentent des vues latérales d'un dispositif d'affichage amovible selon l'invention,
- les figures 9a et 9b montrent respectivement une vue de face et une vue de profil d'un mode de réalisation du dispositif d'affichage amovible selon l'invention.

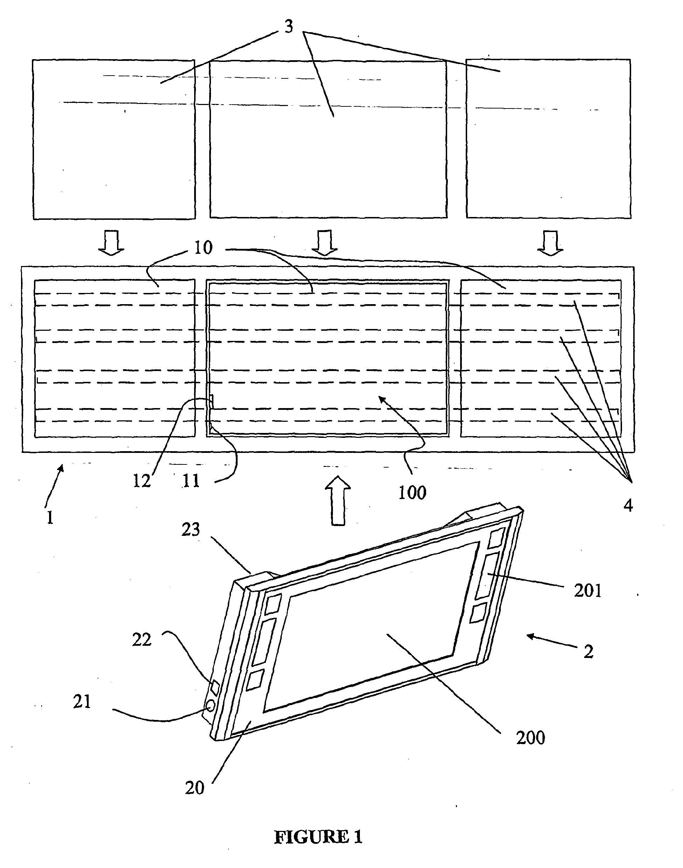

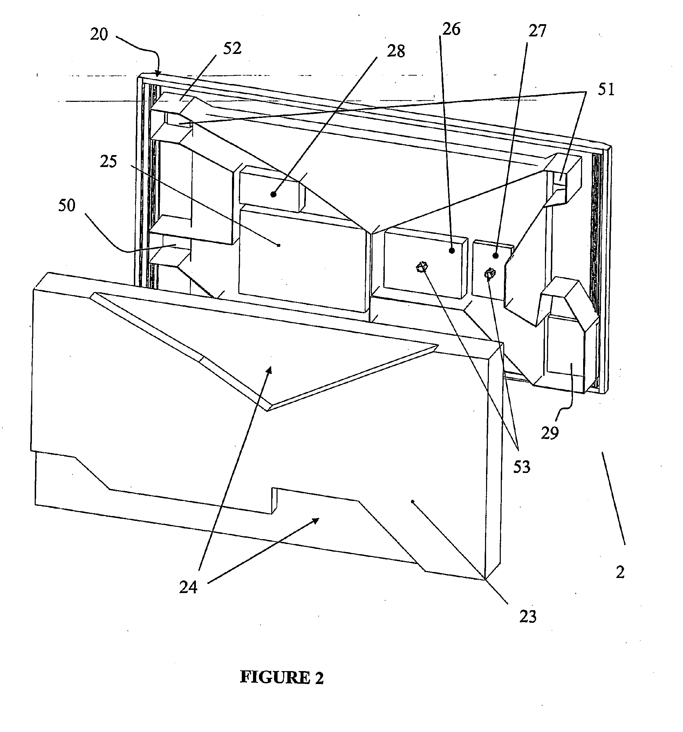

L'invention va être à présent décrite en référence aux figures 1 et 2.

Le système d'affichage dynamique comprend un boîtier (1) pourvu d'une ou plusieurs ouvertures frontales (10) pour permettre la présentation d'informations visuelles par des affiches (3). Ces affiches (3) sont généralement portées par des cadres rigides. Selon l'invention, au moins une ouverture frontale (10) comporte un emplacement frontal (100) de dimensions déterminées, formé par exemple par un logement accessible en l'absence de cadre d'affiche (3) et agencé pour recevoir un dispositif amovible d'affichage à commande numérique (2). Comme représenté à la figure 1, le dispositif amovible (2) comporte une partie avant formée d'un cadre (20) dans lequel est monté un écran de visualisation plat (200). La partie arrière du dispositif amovible d'affichage à commande numérique (2) est fixée au dos de l'écran et éventuellement du cadre. L'écran est par exemple un écran LCD (affichage à cristaux liquides «Liquid Crystal Display ») de grande intensité lumineuse, par exemple de 500 candela ou tout autre écran plat. Cet écran peut être équipé avec une technologie de type TFT (de l'anglais « Thin Film Transistor »). Dans un mode de réalisation de l'invention, la taille de l'ouverture frontale (10) donnant accès à l'emplacement ou logement (100) correspond au format de l'écran qui peut être par exemple, et de manière non limitative, de 20 ou 40 pouces (de 50 à 100 cm). Les écrans peuvent être plus ou moins allongés et atteindre en diagonale des dimensions inférieures à 20 pouces (50 cm) ou supérieures à 40 pouces (100 cm) dans des variantes de réalisation.

Dans l'exemple de la figure 1, le boîtier (1) comprend trois ouvertures (10) de dimensions pouvant varier. Des moyens de support sont prévus dans le boîtier (1) pour porter et maintenir un cadre d'affiche (3) amovible, par exemple selon un plan parallèle à l'ouverture frontale. Dans un mode de réalisation de l'invention, ces moyens de support sont répartis notamment sur les bords horizontaux des ouvertures frontales (10) et peuvent consister en des profilés (16) ayant au moins une gorge de maintien d'un cadre d'affiche (3). Le boîtier (1) illustré à la figure 1 permet ainsi de présenter trois affiches (3) alignées les unes à côté des autres. Ces affiches (3) sont illuminées par un système d'éclairage (4) comprenant des tubes fluorescents. Des tubes fluorescents sont ainsi disposés horizontalement ou verticalement à l'arrière du boîtier (1). Les tubes du système d'éclairage (4) sont répartis sur la hauteur du boîtier (1) pour fournir un éclairage sensiblement homogène des affiches (3).

Le système d'affichage selon l'invention incorpore avantageusement au moins un dispositif amovible (2) d'affichage à commande numérique, positionné dans l'emplacement frontal (100) du boîtier. Dans le mode de réalisation de la figure 1, le système d'affichage intègre un écran (200) vidéo numérique au centre, tandis que les deux autres ouvertures permettent la présentation d'affiches statiques (3) illuminés par le système d'éclairage (4) à tubes fluorescents. N'importe laquelle des deux autres ouvertures peut également comprendre un logement pour recevoir un dispositif à écran numérique de format correspondant. Plus généralement, il peut être envisagé n'importe quelle combinaison d'affiches (3) avec un ou plusieurs écrans. Une particularité du système d'affichage selon l'invention est de permettre l'intégration d'un affichage dynamique à côté d'images statiques. Cela met en valeur et donne un aspect attractif aux informations affichées.

L'écran de visualisation (200) est monté dans un cadre-(20) de forme et dimensions correspondant à un cadre d'affiche (3) associé, des moyens de fixation (non représentés) solidaires du cadre (20) étant prévus pour maintenir l'écran de visualisation (200) en position frontale. On comprend que le système selon l'invention peut comporter des cadres de design analogue pour représenter des affiches statiques et/ou des images dynamiques, de sorte que l'intégration du dispositif amovible (2) dans un boîtier avec des affiches (3) est parfaite. Autrement dit, la différence visuelle entre un dispositif amovible (2) à écran (200) et un cadre d'affiche (3) n'est perceptible que par l'animation des images dans le cas du dispositif amovible (2).

Dans le cas particulier illustré à la figure 1, une troisième affiche dite de remplacement peut être montée dans l'ouverture centrale lorsque le dispositif d'affichage à commande numérique (2) est enlevé. Le système d'éclairage (4) peut être constitué de tubes fluorescents disposés dans le boîtier (1) en arrière de l'emplacement frontal (100) pour fournir à la fois l'éclairage des affiches de gauche, de droite et de l'affiche de remplacement. Le système d'affichage a une épaisseur réduite et est constitué de matériaux légers. Le boîtier (1), les profilés et le cadre (20) sont par exemple composés d'aluminium. Le dispositif amovible (2) est également constitué de composants et de matériaux légers.

Une interface électrique et mécanique est prévue sur le dispositif amovible (2) pour établir de manière détachable à la fois une connexion à une source d'alimentation électrique (11) située dans le boîtier (1) et un maintien du dispositif (2) dans l'emplacement frontal (100). Une fiche de connexion (21) à la source d'alimentation électrique (11) est par exemple placée sur le couvercle (23) ou capot de la partie arrière. Des moyens de raccordement (22) à une connexion (12) du boîtier (1) à un réseau sont également fournis à l'arrière du dispositif amovible (2) pour notamment permettre la transmission et la réception- de données de type numérique, par l'intermédiaire d'au moins un canal bidirectionnel. Il peut s'agir aussi bien d'un réseau de télécommunication que d'un réseau informatique local. Comme représenté à la figure 2, des composants électroniques de gestion et de commande sont fixés à l'arrière de l'écran plat (200), comme par exemple une carte graphique (28) pour l'écran plat de visualisation (200). La partie arrière du dispositif amovible (2), fermée par le couvercle (23), a un format de dimensions inférieures ou égales au format du cadre (20) de la partie avant. Des moyens d'attache (non représentés) permettent de fixer les composants électroniques de gestion et de commande directement à l'arrière de l'écran (200). Ces composants, répartis sur le dos de l'écran de visualisation de la partie avant, sont disposés dans un volume aplati délimité par le couvercle de protection (23) dont l'épaisseur est comprise entre 2 et 10 cm. Les différents composants électroniques sont répartis de manière éclatée et sont disposés à plat au dos de l'écran (200) pour réduire l'épaisseur du dispositif amovible (2).

Une unité centrale (26) à microprocesseur formant un système compatible PC de haute performance (par exemple avec processeur de type Pentium® 4) est ainsi intégrée à l'arrière de l'écran plat (200) sous le couvercle (23) pour notamment gérer des fonctions multimédia de cet écran (200). L'unité centrale (26) de traitement permet de mettre en oeuvre des modules logiciels pour assurer par exemple la gestion d'images, un calendrier de programmation, une télémaintenance, le traitement de données marketing, etc. Dans un mode de réalisation de l'invention, l'unité centrale (26) commande et gère un circuit de commande de son d'une carte son, un circuit de commande des télécommunications, un circuit de commande des entrées, un circuit de commande de la mémorisation de masse, un module d'asservissement vidéo (25) de l'écran de visualisation (200). Pour la reproduction d'informations sonores, le dispositif amovible (2) comporte des haut-parleurs (201) recevant le signal d'un amplificateur-tuner relié à un circuit électronique de type synthétiseur de musique prévu pour supporter un grand nombre de sources d'entrée tout en fournissant une sortie présentant une qualité de type CD. Tout autre moyen utilisant un dispositif de sons digitaux de type DSP (de l'anglais « Digital Signal-Processor ») pourrait également être utilisé. Les haut-parleurs (201) sont par exemple disposés sur la face avant du cadre (20) dans lequel est monté l'écran de visualisation (200).

Des moyens de mémorisation (27) utilisant au moins un disque dur de type à haute vitesse et haute capacité sont par exemple associés aux moyens de mémorisation déjà présents dans l'unité centrale (26). Les moyens de mémorisation (27) peuvent aussi comprendre une ou plusieurs mémoires flash ou tout type connu de mémoire d'accès rapide Ces moyens de mémorisation (27) servent au stockage d'informations numérisées et compressées représentatives d'images et d'animations audio-vidéo/numériques. Il est ainsi possible de conserver une bibliothèque d'images, d'animations de synthèse et d'informations vidéo, l'unité de traitement permettant de gérer cette bibliothèque. Le dispositif d'affichage à commande numérique (2) comprend également un modem de télécommunication par exemple de type RNIS (Réseau Numérique à Intégration de Services), RTC (Réseau Téléphonique Commuté) ou utilisant par exemple la technologie DSL ou ADSL (pour "Asynchrone Digital Subscriber Line") ou du type associé à un réseau de radiotéléphonie ou tout autre matériel de télécommunication associé à d'autres médias de télécommunication intégrés pour autoriser la liaison avec un réseau de distribution d'informations audiovisuelles contrôlé par un serveur central. Le dispositif amovible d'affichage à commande numérique (2) peut donc être contrôlé à distance par un serveur de programmation connecté au réseau de télécommunication et disposant de sources d'informations à télé-transmettre, ces sources d'informations incluant notamment des données vidéo et d'animations. Ledit serveur de programmation permet de contrôler un équipement de télémaintenance dudit dispositif (2). Ainsi, l'état du système d'affichage et le déroulement des programmes à diffuser peuvent être contrôlés. Des modifications sont permises, par exemple de manière automatique lors d'un événement particulier ou également en cas de détection d'un dysfonctionnement.

Dans un mode de réalisation de l'invention, une alimentation thermiquement régulée de 240 watts ventilée ou autre alimentation d'un type connu fournit l'énergie au système. Cette alimentation est par exemple protégée contre les surintensités et les suroscillations. Le couvercle. (23) peut comprendre des portions (24) de forme adaptée avec relief ou renfoncement pouvant correspondre à l'emplacement des sources fluorescentes du système d'éclairage (4). On comprend que l'emplacement frontal (100) ou logement du boîtier (1) a un volume déterminé pour contenir la partie arrière du dispositif amovible (2), par exemple égal au volume occupé par le dispositif amovible (2), et est agencé pour diminuer au maximum l'épaisseur du système d'affichage selon l'invention. Les composants électroniques à l'arrière de l'écran (200), confiné sous le couvercle (23), sont refroidis par un système de ventilation naturelle ou forcée. Comme représenté à la figure 2, au moins un extracteur d'air (51) peut être prévu à proximité d'un conduit de sortie de ventilation. Un ou plusieurs conduits d'arrivée de ventilation (50) amènent de l'air dans la partie arrière du dispositif amovible d'affichage à commande numérique (2). Ces moyens d'évacuation de l'air chauffé par les composants électroniques et les composants d'affichage sont par exemple disposés sur les côtés de la partie arrière protégée par le couvercle (23). Le système de ventilation peut être complété par un système de refroidissement localisé pour évacuer la chaleur dégagée par un des composants électroniques de gestion et de commande. Le systèmes de refroidissement peut inclure une ou plusieurs cellules à effets Pelletier (53), servant notamment à refroidir le microprocesseur de l'unité de traitement (26). N'importe quel autre composant (25, 27, 28) peut être également être refroidi de cette façon. Dans la figure 2, des cloisons (52) de canalisation du flux d'air sont représentées dans la partie arrière du dispositif (2) pour délimiter au moins une zone restreinte d'aération forcée autour des composants électroniques. Un système échangeur de chaleur caloduc peut aussi être utilisé pour refroidir l'unité de traitement (26) ou d'autres composants (25, 27, 28).

Dans l'exemple de la figure 2, le dispositif amovible d'affichage à commande numérique (2) comprend un lecteur (29) de disques supports de données numériques. Un opérateur peut ainsi manipuler le système d'affichage en choisissant un support tel qu'un disque DVD (Digital Versatile Disc) pouvant être lu par le lecteur pour diffuser des informations de type numérique sur l'écran (200).

L'écran de visualisation (200) du dispositif amovible (2) a des dimensions déterminées sensiblement égales aux dimensions de l'ouverture frontale (10). Des moyens d'adaptation sont prévus dans le module d'asservissement vidéo (25) de l'écran (200) pour adapter des données numériques représentatives de vidéo et/ou animations au format de l'écran de visualisation (200). Un format vidéo 4/3, 16/9 ou autre peut donc être utilisé sans que n'apparaissent à l'écran des effets de déformation.

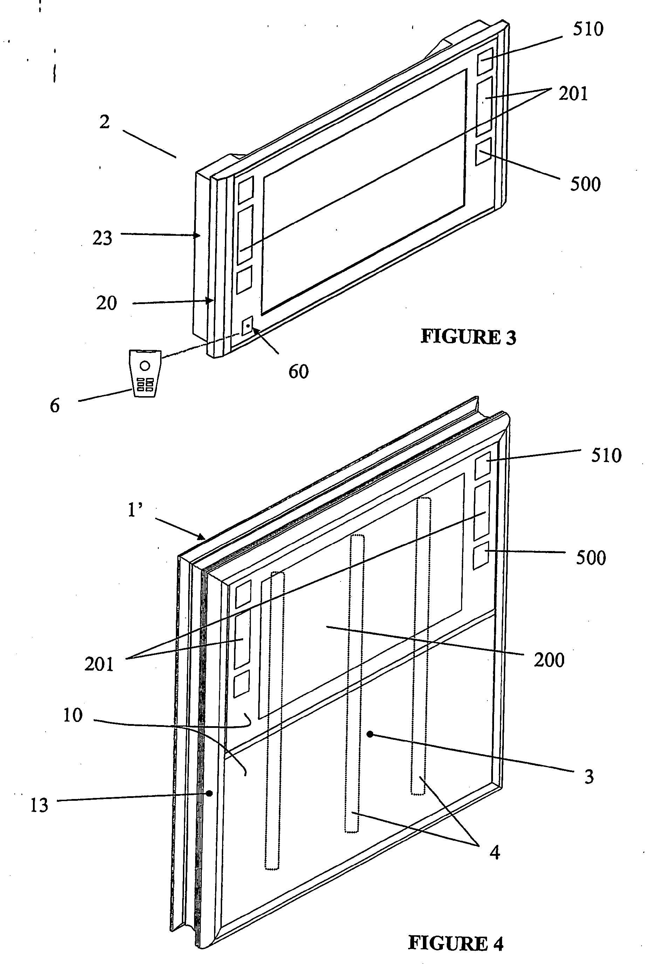

L'invention va être à présent décrite en liaison avec les figures 3 et 4. Dans le mode de réalisation de la figure 3, le dispositif d'affichage à commande numérique (2) est équipé d'un circuit d'entrée interface également avec un ensemble à télécommande (6) constitué, par exemple
- d'une télécommande (6) infrarouge émetteur permettant notamment de commander l'unité de traitement (26),
- d'un récepteur infrarouge (60) avec adaptateur.

Un système hertzien, une commande à puce électronique de type Bluetooth®, un réseau interne, un système avec clavier ou autre système connecté physiquement peut aussi être envisagé. La télécommande (6) permet à un opérateur, par exemple un gérant de restaurant ou bar, d'accéder logiciel de programmation stocké dans les moyens de mémorisation (26) et de contrôler différentes commandes telles que la commande de mise en sourdine des haut-parleurs (201), la commande de contrôle de volume sonore, la commande marche/arrêt, la commande pour contrôler le lecteur (29) de disques vidéo, la commande de programmation pour faire apparaître un menu de sélection et choisir un fichier dans une bibliothèque des moyens de mémorisation (27) ou des données numériques disponibles sur un serveur du réseau auquel est relié le système d'affichage, etc. Le dispositif amovible (2) d'affichage à commande numérique peut comprendre d'autres types d'interfaces avec l'utilisateur reliés par une connexion physique à l'unité de traitement pour permettre un contrôle de l'affichage sur l'écran, par utilisation d'un logiciel de programmation stocké dans les moyens de mémorisation (26).

Chaque entrée de ventilation (500) peut avantageusement être pourvue d'un filtre ou d'une grille pour retenir notamment les poussières. Dans une variante, l'entrée de ventilation (500) comprend une grille ou un système de filtration pour retenir les vapeurs d'huiles, -corps gras et autres particules (particules de fumée etc.). Un grillage métallique peut être prévu devant les ouvertures d'entrée et/ou de sortie (500, 510), la dimension de maille de ce grillage étant déterminée pour supprimer ou limiter l'émission d'ondes. Dans une variante de réalisation, une laine métallique ou structure analogue, incorporant des particules de charbon actif, est disposée dans les ouvertures pour d'une part supprimer ou limiter l'émission d'ondes et d'autre part fixer et oxyder les particules d'huile. Comme représenté dans les figures 3 et 4, les sorties de ventilation forcée (510) peuvent être disposées dans la partie supérieure, par exemple les angles supérieurs de la face avant, du dispositif (2) d'affichage à commande numérique.

La figure 4 illustre un mode de réalisation de l'invention dans lequel le dispositif amovible (2) est inséré dans un boîtier lumineux (1') comprenant deux ouvertures frontales (10). Les tubes fluorescents du système d'éclairage (4) sont disposés derrière le dispositif (2) d'affichage à commande numérique et permettent d'éclairer une affiche (3) présentée ici au-dessous de l'écran plat (200) de l'écran vidéo numérique. Les positions respectives de l'écran et de l'affiche sont naturellement interchangeables. Le dispositif amovible (2) est en effet dimensionné pour être interchangeable avec un cadre d'affiche (3) présenté à travers ladite ouverture frontale (10), les moyens de support (16) de cadre d'affiche (3) étant agencés pour s'attacher à des moyens de fixation rapide du dispositif amovible (2). Le système d'éclairage (4) comprend par exemple au moins un tube fluorescent disposé parallèlement aux ouvertures frontales. Le boîtier (1') de la figure 4 comprend ainsi plusieurs tubes verticaux, par exemple de trois à six tubes, s'étendant sensiblement sur toute la hauteur du boîtier (1'). En variante, les tubes fluorescents peuvent être inclinés. Le couvercle (23) du dispositif (2) présente des propriétés de protection contre les rayonnements optiques et électromagnétiques pour éviter l'échauffement et l'usure des composants électroniques. Dans un mode de réalisation de l'invention, le couvercle de protection (23) inclut un matériau métallique ayant des propriétés réfléchissantes. Le couvercle est par exemple réalisé en métal et permet de supprimer ou de limiter l'émission d'ondes électromagnétiques vers l'extérieur en provenance des composants électroniques.

On comprend que le système d'affichage permet de positionner un écran (200) dynamique à côté au-dessus, en dessous ou au milieu d'une ou plusieurs affiches statiques illuminées par le système d'éclairage (4) du boîtier (1'). Dans le mode de réalisation de la figure 4, le boîtier (1') comprend un cadre ouvrant (13) à fenêtre(s) transparente(s) qui est articulé pour être rabattu sur les ouvertures frontales (10). En variante, le cadre ouvrant (13) peut simplement être démontable et éventuellement décomposé en plusieurs parties correspondant aux ouvertures frontales (10).

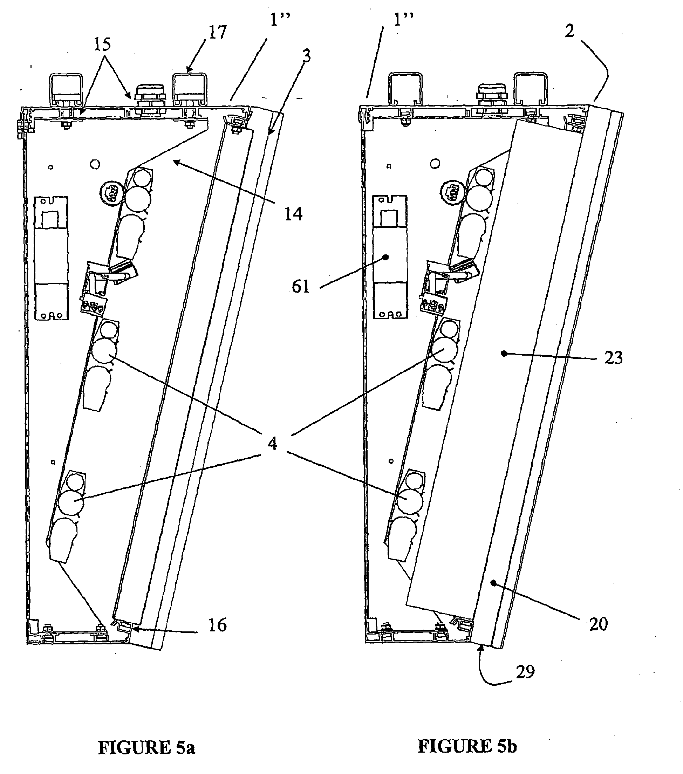

L'invention va être à présent décrite en liaison avec les figures 1, 5a et 5b.

Dans le mode de réalisation des figures 5a et 5b, le boîtier (1") est sensiblement en forme de trapèze. Il comprend un bas et un haut horizontaux, le fond du boîtier étant sensiblement vertical. Il dispose d'une ouverture frontale (10) pour le dispositif amovible (2) d'affichage à commande numérique, inclinée d'un angle compris entre 0 et 30°. L'épaisseur maximale du boîtier (1") reste inférieure à 30 cm. Le système d'éclairage (4) est formé par des sources d'éclairage telles que des tubes à néon fluorescents, réparties sur la hauteur du boîtier (1"). Le système d'éclairage (4) peut être supporté par un dispositif raidisseur (14) fixé au boîtier-(1") par des moyens de fixation (15). Un système d'alimentation (61) des tubes fluorescents est intégré à l'arrière du boîtier (1").

L'ouverture frontale (10) peut être orientée vers le bas, le boîtier (1") étant destiné à être suspendu en hauteur et/ou fixé contre un mur. Le système d'affichage comprend un minimum de connexions et forme un écran de cantonnement (écran pare-fumée et stable au feu de 15 à 30 minutes). La face avant du dispositif amovible peut être dépourvue de fiches de connexion électrique. La figure 5a montre le système d'affichage avec présentation d'une affiche (3) statique insérée dans des moyens de support (16). Ces moyens de support peuvent consister en des profilés placés en bordure de l'ouverture frontale permettant de maintenir et de présenter l'affiche (3) à travers l'ouverture frontale (10). Dans un mode de réalisation de l'invention, le boîtier (1") comporte des profilés horizontaux disposés en bas et en haut de l'ouverture (10) aptes à s'accrocher avec des profilés complémentaires placés sur le dispositif amovible (2). Les cadres d'affiches peuvent également être pourvus de tels-profilés complémentaires pour se fixer de la même manière que le dispositif amovible. Ainsi-les profilés de l'ouverture frontale (10) sont aptes à se fixer sur des profilés complémentaires situés à la périphérie respectivement des cadres d'affiches (3) et du dispositif amovible (2). D'autres systèmes de fixation d'un type connu peuvent naturellement être envisagés sur le dispositif amovible (2) pour former une interface mécanique apte à maintenir fixement et de manière amovible le dispositif (2) dans le l'emplacement (100). La figure 5b montre le système d'affichage avec le dispositif amovible (2) d'affichage à commande numérique encastré dans le boîtier (1"). Le dispositif amovible (2) est maintenu et alimenté en courant par l'intermédiaire de l'interface électrique et mécanique. Dans le mode de réalisation des figures 5a et 5b, la disposition des profilés constituant à la fois les moyens de support de cadres d'affiches (3) et du dispositif amovible (2) est étudiée pour permettre une répartition optimisée du poids dans le boîtier (1"). Le système d'affichage peut ainsi être suspendu par exemple à des rails (17) fixés à un plafond. Le système selon l'invention a donc une charge répartie de manière homogène, contrairement à la plupart des appareils d'affichage connus. Le lecteur (29) de disques supports de données vidéo numériques comprend une trappe d'introduction située à l'extérieur de l'emplacement (100) où vient s'encastrer la partie arrière du dispositif amovible (2). Les figures 5a et 5b peuvent correspondre à des vues en coupe d'un système d'affichage à plusieurs ouvertures (10) tel que celui présenté à la figure 1. L'encadrement des ouvertures (10) peut être réalisé avec des profilés dont la forme est par exemple fonction du format du boîtier (1 "). Ces profilés forment un ou plusieurs cadres ouvrants (13) dotés de systèmes d'accroche rapide pour facilement se démonter. De tels profilés sont également opaques et montés de manière à complètement obturer les rayons lumineux provenant de l'intérieur du boîtier (1").

Le couvercle (23) est positionné à faible distance du système d'éclairage (4) pour ne pas accroître l'épaisseur du boîtier (1"). Le système d'affichage selon l'invention peut donc disposer de l'ensemble des caractéristiques d'un boîtier lumineux classique de type menu board pour présenter des affiches (3) statiques, comme illustré à la figure 5a, tout en permettant l'intégration d'un dispositif (2) d'affichage à commande numérique par simple connexion dans des fiches de connexion d'un emplacement (100) ou logement du boîtier (1"). La conception du système permet la coexistence d'éléments dans un milieu confiné soumis à des contraintes d'échauffement et de rayonnement, tout en répartissant de façon homogène la charge de ces éléments dans le boîtier (1).

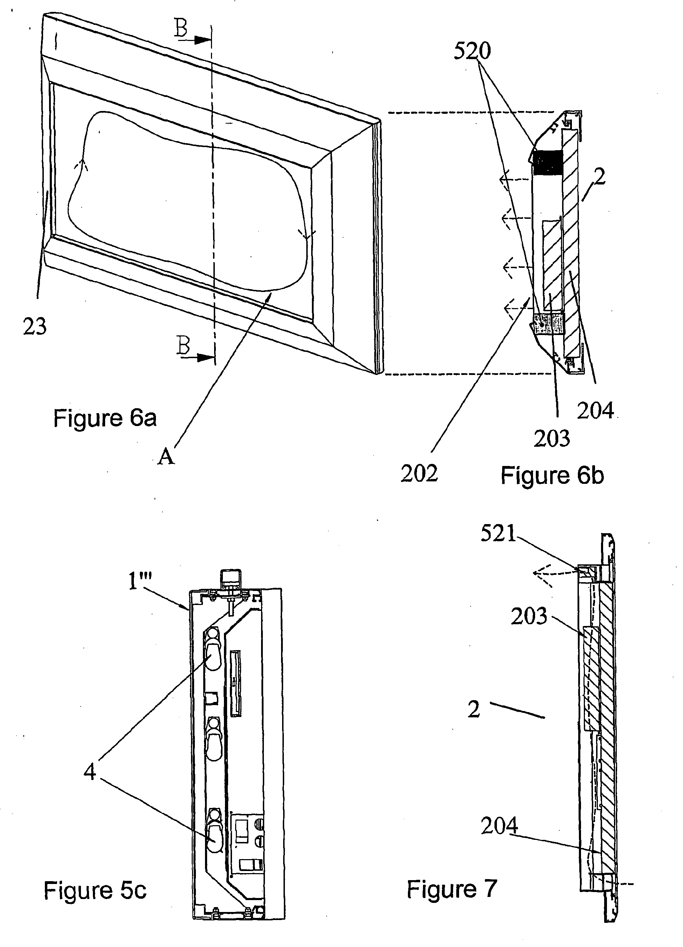

En référence à la figure 5c, le boîtier (1"') peut avoir une forme parallélépipédique, par exemple rectangulaire. La face avant est alors parallèle au fond du boîtier (1'").

Dans le mode de réalisation des figures 6a et 6b, le boîtier peut être étanche et donc dépourvu d'ouvertures d'aération. Un refroidissement par effet radiateur et un recyclage d'air intérieur permettent d'homogénéiser la température intérieure du dispositif amovible (2), celle-ci restant à un niveau peu élevé, à une température par exemple inférieure à 40°C. La surface arrière (202) ou la totalité du couvercle (23) du dispositif amovible d'affichage (2), par exemple à base d'aluminium (fonte d'alumine) ou autre métal adapté, assure une transmission de chaleur par rayonnement et par convection. Comme illustré à la figure 6b, un ensemble de ventilation (520) radiale est prévu dans la partie arrière du dispositif amovible d'affichage (2) pour optimiser cette transmission de chaleur à travers le couvercle (23). Autrement dit, le couvercle (23) joue le rôle d'un échangeur thermique avec l'extérieur. L'utilisation d'au moins deux ventilateurs pour réaliser une ventilation radiale dans le dispositif amovible d'affichage (2) permet d'assurer une circulation d'air dans un sens rotatoire (A), comme illustré à la figure 6a. Dans le mode de réalisation de la figure 6a, un gaufrage est réalisé pour le couvercle (23) afin qu'une tenue mécanique constante soit obtenue tout en réduisant l'épaisseur grâce à l'augmentation de l'inertie de section du couvercle (23). Les échanges thermiques avec l'extérieur sont ainsi améliorés puisque du fait de la réduction d'épaisseur, la résistance thermique du couvercle (23) est moindre, et la surface d'échange thermique avec l'air intérieur à refroidir est augmentée.

L'invention va être à présent décrite en liaison avec les figures 7, 8, 8a et 8b, 9a et 9b.

Dans des variantes de réalisation, un dispositif de brassage de l'air interne est prévu avec au moins un ventilateur (521) disposé de façon tangentielle pour abaisser la température intérieure dans le dispositif d'affichage amovible (2), en particulier dans une zone de circulation d'air de refroidissement traversait les composants électroniques à fort dégagement calorifique (203). Comme illustré à la figure 7 pour un écran de grande taille (de 40 pouces par exemple), la circulation d'air tangentielle horizontale représentée par la flèche en pointillé longe également les composants électroniques de moindre dégagement calorifique (204). L'extraction d'air réchauffé se fait par l'arrière du dispositif d'affichage amovible (2).

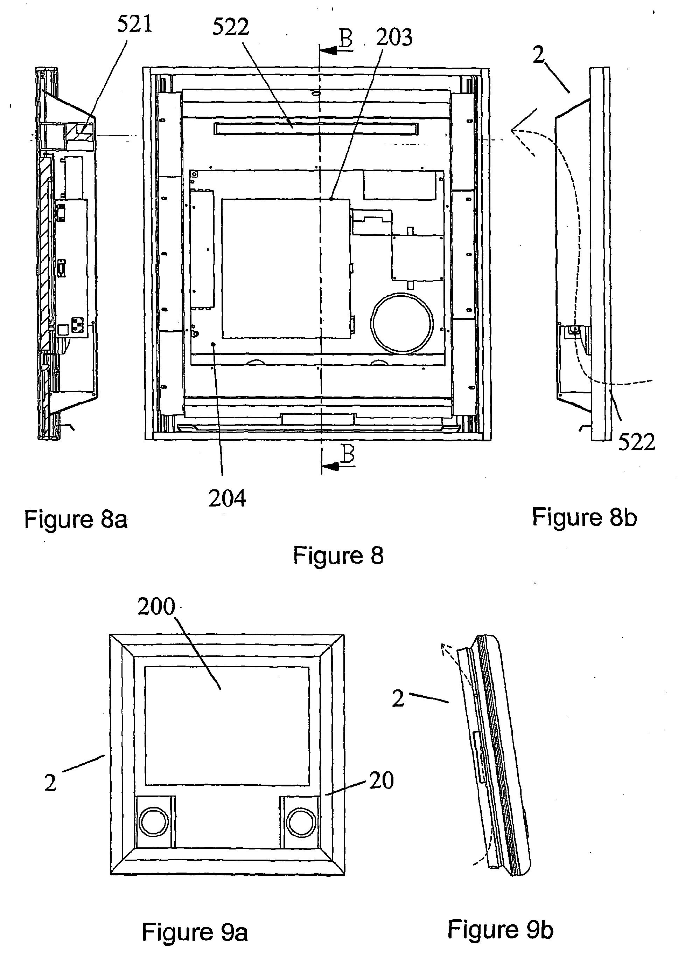

En référence aux figures 7, 8a et 8b, la circulation d'air peut être ascendante, avec au moins une entrée (522) à l'avant du dispositif (2) en dessous de l'écran plat et une sortie d'extraction (523) à l'arrière du dispositif (2). Au moins un ventilateur (521) disposé de façon tangentielle est prévu près de la sortie d'extraction (522) pour extraire l'air réchauffé. Dans le mode de réalisation des figures 9a et 9b, le refroidissement peut être effectué par convection naturelle. Le dispositif (2) est d'un format adapté en fonction de l'emplacement (100) du boîtier laissé libre par l'affiche. Ainsi le cadre (20) peut être sensiblement carré avec un écran de 20 pouces (50 cm), comme illustré à la figure 9a.

Le dispositif amovible (2) d'affichage à commande numérique peut s'adapter dans des caissons ou boîtiers existants, des moyens de fixation étant prévus pour permettre l'encastrement dans un caisson en utilisant ou non le moyen de support (16) de cadre d'affiche du caisson. Des moyens de fixations complémentaires incluant par exemple des rails ou nervures de guidage peuvent permettre la fixation du dispositif (2). Des premier et second rails horizontaux montés dans le boîtier permettent par exemple de fixer respectivement le dessus et le dessous du dispositif (2). L'enlèvement du dispositif (2) peut s'effectuer en deux temps, avec d'abord un désengagement du haut du dispositif (2) par rapport au premier rail puis un désengagement du bas du dispositif (2) par rapport au second rail.

Un des avantages du système d'affichage selon l'invention est la modularité et la flexibilité de l'affichage dynamique, l'écran vidéo numérique se présentant sous la forme d'un dispositif amovible (2) pouvant aisément être ajouté ou enlevé. Le système d'affichage dynamique est en outre particulièrement bien adapté pour une utilisation dans les cafés et les grandes chaînes de restauration, les ouvertures d'aération étant soit supprimées soit munies d'un filtre ou d'une grille spécifique pour empêcher l'encrassement des parties intérieures et limiter l'émission d'ondes électromagnétiques.

Il doit être évident pour les personnes versées dans l'art que la présente invention permet des modes de réalisation sous de nombreuses autres formes spécifiques sans l'éloigner du domaine d'application de l'invention comme revendiqué.

## Revendications

1. Système d'affichage dynamique comprenant un boîtier (1, 1', 1", 1"') pourvu d'au moins une ouverture frontale (10) et au moins un moyen de support (16) dans le boîtier (1, 1', 1", 1"') pour porter au moins un cadre d'affiche (3) amovible, un système d'éclairage (4) réparti dans le boîtier (1, 1', 1", 1"') pour fournir un rétro-éclairage des affiches (3), **caractérisé en ce qu'**au moins un dispositif amovible (2) d'affichage à commande numérique est prévu en échange d'au moins un cadre d'affiche (3) pour couvrir la ou lesdites ouverture(s) frontale(s) (10), le dispositif amovible (2) incluant une partie dite avant, formée d'un cadre (20) et d'un écran de visualisation plat (200) monté dans le cadre (20), et une partie arrière de commande et gestion fixée au dos de la partie avant, une interface électrique et mécanique étant prévue sur le dispositif amovible (2) pour établir de manière détachable à la fois une connexion à une source d'alimentation électrique située dans le boîtier (1, 1', 1", 1"') et une fixation du dispositif dans un emplacement frontal (100) du boîtier (1,1', 1 ", 1"').

2. Système d'affichage dynamique selon la revendication 1, dans lequel l'écran de visualisation (200) est monté dans un cadre (20) de forme et dimensions correspondant à un cadre d'affiche (3) associé, des moyens de fixation solidaires du cadre (20) étant prévus pour maintenir l'écran de visualisation (200) en position frontale.

3. Système d'affichage dynamique selon la revendication 1 ou 2, dans lequel le dispositif amovible (2) est dimensionné pour être interchangeable avec un cadre d'affiche (3) présenté à travers ladite ouverture frontale (10), les moyens de support (16) de cadre d'affiche (3) étant agencés pour s'attacher à des moyens de fixation rapide du dispositif amovible (2).

4. Système d'affichage dynamique selon une des revendications 1 à 3, dans lequel le système d'éclairage (4) comprend au moins un tube fluorescent, la partie arrière du dispositif amovible (2) d'affichage à commande numérique comportant un couvercle (23) de protection contre les rayonnements optiques et électromagnétiques.

5. Système d'affichage dynamique selon l'une quelconque des revendications 1 à 4, dans lequel la partie arrière du dispositif amovible (2) a un format de dimensions inférieures ou égales au format du cadre (20) de la partie avant, la partie arrière comportant des composants électroniques de gestion et de commande fixés par des moyens d'attache et répartis sur le dos de l'écran de visualisation (200) constituant la partie avant, l'ensemble des composants électroniques étant disposé dans un volume aplati et de forme adaptée délimité par un couvercle (23) de protection dont l'épaisseur est comprise entre 2 et 10 cm.

6. Système d'affichage dynamique selon l'une quelconque des revendications 1 à 5, dans lequel la partie arrière de l'écran (200) comprend notamment :
- un module d'asservissement vidéo (25) de l'écran plat (200),
- des moyens de carte graphique avec ou sans carte son,
- une unité de traitement (26) pour la mise en oeuvre de modules logiciels et notamment la gestion de fonctions multimédia de l'écran plat (200),
- des moyens de mémorisation (27) pour stocker des données représentatives d'images et d'animations audio-vidéo/numériques.

7. Système d'affichage dynamique selon l'une quelconque des revendications 1 à 6, dans lequel le dispositif amovible (2) comporte des moyens de communication et raccordement (22) à un réseau pour transmettre et recevoir notamment des données de type audio-vidéo numériques par l'intermédiaire d'au moins un canal bidirectionnel.

8. Système d'affichage dynamique selon l'une quelconque des revendications 5 à 7, dans lequel le dispositif amovible (2) d'affichage à commande numérique comporte des moyens d'évacuation de l'air chauffé par les composants électroniques de gestion et de commande et des composants d'affichage.

9. Système d'affichage dynamique , selon l'une quelconque des revendications 5 à 8, dans lequel la partie arrière comprend au moins un système de refroidissement localisé pour évacuer la chaleur dégagée par au moins un des composants électroniques de gestion et de commande.

10. Système d'affichage dynamique selon la revendication 8 ou 9, dans lequel le dispositif amovible d'affichage (2) comporte une entrée de ventilation (500) munie d'un système de filtration pour retenir les vapeurs d'huiles, corps gras et autres particules.

11. Système d'affichage dynamique selon l'une quelconque des revendications 4 à 10, dans lequel l'emplacement frontal (100) du boîtier (1, 1', 1", 1"') a un volume déterminé pour contenir la partie arrière du dispositif amovible (2), le couvercle de protection (23) incluant un matériau métallique ayant des propriétés réfléchissantes, le boîtier comprenant un cadre ouvrant (13) à fenêtre amovible ou articulé pour être rabattu sur l'ouverture frontale (10).

12. Système d'affichage dynamique selon l'une quelconque des revendications 1 à 11, dans lequel le dispositif amovible (2) comprend un lecteur (29) de disques supports de données numériques.

13. Système d'affichage dynamique selon la revendication 12, dans lequel le lecteur (29) est agencé pour être directement accessible par une trappe d'introduction située à l'extérieur de l'emplacement frontal.

14. Système d'affichage dynamique selon l'une quelconque des revendications 6 à 13, dans lequel l'écran de visualisation (200) du dispositif amovible (2) a des dimensions déterminées sensiblement égales aux dimensions de l'ouverture frontale (10), des moyens d'adaptation étant prévus dans le module d'asservissement vidéo (25) de l'écran pour adapter des données numériques représentatives de vidéo et/ou animations au format de l'écran de visualisation (200).

15. Système d'affichage dynamique selon l'une quelconque des revendications 1 à 14, dans lequel les moyens de support (16) de cadres d'affiches (3) consistent en des profilés de maintien disposés en bordure de l'ouverture frontale (10) et- aptes à se fixer sur des profilés complémentaires situés à la périphérie respectivement des cadres d'affiches (3) et du dispositif amovible (2).

16. Système d'affichage dynamique selon l'une quelconque des revendications 6 à 15, dans lequel le dispositif amovible (2) d'affichage à commande numérique comprend des moyens d'interface utilisateurs reliés par une connexion physique et/ou à distance à l'unité de traitement (26) pour permettre un contrôle de l'affichage sur l'écran (200), par utilisation d'un logiciel de programmation stocké dans les moyens de mémorisation (27).

17. Système d'affichage dynamique selon l'une quelconque des revendications 7 à 16, dans lequel le dispositif amovible (2) d'affichage à commande numérique est contrôlé à distance par un serveur de programmation connecté au réseau et disposant de sources d'informations à télé-transmettre, ces sources d'informations incluant notamment des données numériques, ledit serveur de programmation contrôlant un équipement de télémaintenance dudit dispositif (2).

18. Système d'affichage dynamique selon l'une quelconque des revendications 1 à 17, dans lequel le boîtier (1, 1', 1 ", 1"') est sensiblement en forme de trapèze, le boîtier comprenant un bas et un haut horizontaux, le fond du boîtier étant sensiblement vertical, l'ouverture frontale (10) pour le dispositif amovible (2) d'affichage à commande numérique étant inclinée d'un angle compris entre 0 et 30°, l'épaisseur maximale du boîtier restant inférieure à 30 cm et ayant une épaisseur minimale de l'ordre de 10 cm, le système d'éclairage (4) comprenant des moyens d'éclairage répartis sur la hauteur du boîtier.

19. Système d'affichage dynamique selon l'une quelconque des revendications 1 à 18, dans lequel des cloisons de canalisation du flux d'air (52) sont prévues dans la partie arrière pour délimiter au moins une zone restreinte d'aération forcée autour de composants électroniques.

20. Dispositif amovible (2) d'affichage à commande numérique destiné à remplacer au moins un cadre d'affiche (3) dans un caisson ou boîtier (1,1',1", 1"') du type à rétro-éclairage d'affiche et pourvu d'au moins un moyen de support (16) pour porter au moins un cadre d'affiche (3) amovible et au moins une ouverture frontale (10) avec emplacement frontal (100) de dimension déterminées, le dispositif (2) étant **caractérisé en ce qu'**il comporte une interface électrique et mécanique pour établir de manière détachable à la fois une connexion à une source d'alimentation électrique située dans le boîtier (1, 1', 1 ", 1"') et une fixation du dispositif (2) dans l'emplacement frontal (100), une partie dite avant, formée d'un cadre (20) et d'un écran de visualisation plat (200) monté dans le cadre (20), et une partie arrière de commande et gestion fixée au dos de la partie avant.

21. Dispositif amovible (2) d'affichage selon la revendication 20, dans lequel l'écran de visualisation (200) est monté dans un cadre (20) de forme et dimensions correspondant à un cadre d'affiche (3) associé, des moyens de fixation solidaires du cadre (20) étant prévus pour maintenir l'écran de visualisation (200) en position frontale.

22. Dispositif amovible (2) d'affichage selon la revendication 20 ou 21, dans lequel la partie arrière du dispositif amovible (2) d'affichage à commande numérique comporte un couvercle (23) de protection contre les rayonnements optiques et électromagnétiques.

23. Dispositif amovible (2) d'affichage selon une des revendications 20 à 22, dans lequel la partie arrière du dispositif amovible (2) a un format de dimensions inférieures ou égales au format du cadre (20) de la partie avant, la partie arrière comportant des composants électroniques de gestion et de commande fixés par des moyens d'attache et répartis sur le dos de l'écran de visualisation (200) constituant la partie avant, l'ensemble des composants électroniques étant disposé dans un volume aplati et de forme adaptée délimité par un couvercle (23) de protection dont l'épaisseur est comprise entre 2 et 10 cm.

24. Dispositif amovible (2) d'affichage selon une des revendications 20 à 23, dans lequel la partie arrière de l'écran (200) comprend notamment :
- un module d'asservissement vidéo (25) de l'écran plat (200),
- des moyens de carte graphique et carte son,
- une unité de traitement (26) pour la mise en oeuvre de modules logiciels et notamment la gestion de fonctions multimédia de l'écran plat (200),
- des moyens de mémorisation (27) pour stocker des données représentatives d'images et d'animations audio-vidéo/numériques.

25. dispositif amovible (2) d' affichage selon une des revendications 20 à 24, comportant des moyens de communication et raccordement (22) à un réseau pour transmettre et recevoir notamment des données de type audio-vidéo numériques par l'intermédiaire d'au moins un canal bidirectionnel.

26. Dispositif amovible (2) d'affichage selon une des revendications 20 à 25, comportant une entrée de ventilation (500) munie d'un système de filtration pour retenir les vapeurs d'huiles, corps gras et autres particules (fumée, etc.).

27. Dispositif amovible (2) d'affichage selon une des revendications 23 à 26, comportant des moyens d'évacuation de l'air chauffé par les composants électroniques de gestion et de commande et des composants d'affichage.

28. Dispositif amovible (2) d'affichage selon une des revendications 23 à 26, **caractérisé en ce qu'**il est du type sans ouverture d'aération et comporte un ensemble de ventilation (520) radiale prévu pour brasser l'air chauffé par les composants électroniques de gestion et de commande et assurer une transmission de chaleur à travers le couvercle de protection (23), ledit couvercle (23) étant à base d'un métal adapté pour transmettre la chaleur par convention et par rayonnement.

29. Dispositif amovible (2) d'affichage selon une des revendications 20 à 26, dans lequel ladite partie arrière est dotée d'au moins un ventilateur (521) disposé de façon tangentielle pour produire une circulation d'air ascendante, au moins une entrée d'aération (522) étant prévue à l'avant du dispositif (2) en dessous de l'écran de visualisation (200) et une sortie d'extraction (523) à l'arrière du dispositif (2).

30. Dispositif amovible (2) d'affichage selon une des revendications 24 à 29, dans lequel l'écran de visualisation (200) a des dimensions déterminées sensiblement égales aux dimensions de l'ouverture frontale (10), des moyens d'adaptation étant prévus dans le module d'asservissement vidéo (25) de l'écran pour adapter des données numériques représentatives de vidéo et/ou animations au format de l'écran de visualisation (200).

31. Dispositif amovible (2) d'affichage selon une des revendications 25 à 30, comportant un équipement de télémaintenance contrôlable à distancé par un serveur de programmation connecté au réseau et disposant de sources d'informations à télé-transmettre, ces sources d'informations incluant notamment des données numériques.

32. Dispositif amovible (2) d'affichage selon une des revendications 20 à 31, dans lequel le dispositif amovible (2) comprend un lecteur (29) de disques supports de données numériques.

33. Dispositif amovible selon la revendication 32, dans lequel le lecteur (29) est agencé pour être directement accessible par une trappe d'introduction située à l'extérieur de l'emplacement frontal.

## Claims

1. Dynamic display system comprising a housing (1, 1', 1", 1"') provided with at least one front opening (10) and at least one support means (16) in the housing (1, 1', 1", 1"') for supporting at least one removable poster frame (3), a lighting system (4) distributed in the housing (1, 1', 1", 1'") to provide backlighting for the posters (3), **characterised in that** at least one removable digitally controlled display device (2) is provided instead of at least one poster frame in order to cover the said front opening(s), wherein the removable device (2) includes a part referred to as the front part, formed by a frame (20) and a flat display screen (200) mounted in the frame (20), and a rear control and management part fixed to the back of the front part, an electrical and mechanical interface being provided on the removable device (2) in order to establish in a detachable manner both a connection to an electrical power supply situated in the housing (1, 1', 1", 1'") and fixing of the device in a frontal location (100) of the housing (1, 1', 1", 1"').

2. Dynamic display system as claimed in Claim 1, wherein the viewing screen (200) is mounted in a frame (20) with a shape and dimensions corresponding to an associated poster frame (3), fixing means attached to the frame being provided in order to retain the display screen (200) in a frontal position.

3. Dynamic display system as claimed in Claims 1 or Claims 2, wherein the removable device (2) is dimensioned so as to be interchangeable with a poster frame (3) presented through the said front opening (10), the support means (16) of the poster frame (3) being arranged so as to be attached to quick-fixing means on the removable device (2).

4. Dynamic display system as claimed in any one of Claims 1 to 3, wherein the lighting system (4) comprises at least one fluorescent tube, the rear part of the removable digitally controlled display device (2) including a cover (23) for protection against optical and electromagnetic radiation.

5. Dynamic display system as claimed in any one of Claims 1 to 4, wherein the rear part of the removable device (2) has a format with dimensions less than or equal to the format of the frame (20) of the front part, the rear part including electronic management and control components fixed by attachment means and distributed over the back of the display screen (200) constituting the front part, all of the electronic components being disposed in a fattened volume of suitable shape delimited by a protective cover of which the thickness is between 2 and 10 cm.

6. Dynamic display system as claimed in any one of Claims 1 to 5, wherein the rear part of the screen (200) includes in particular:
- a video control module (25) for the flat screen (200),
- graphics card means with or without a sound card,
- a professing unit (26) for the execution of software modules and in particular the management of multimedia functions on the flat screen (200),
- storage means (27) for storing data representing images and audiovisual/digital animations.

7. Dynamic display system as claimed in any one of Claims 1 to 6, wherein the removable device (2) includes means for communication and connection (22) to a network in order to transmit and to receive in particular data of the digital audiovisual type via at least one two-way channel.

8. Dynamic display system as claimed in any one of Claims 5 to 7, wherein the removable digitally controlled display device (2) includes means for removal of air heated by the electronic management and control components and the display components.

9. Dynamic display system as claimed in any one of Claims 5 to 8, wherein the rear part comprises at least one local cooling system for removal of the heat given off by at least one of the electronic management and control components.

10. Dynamic display system as claimed in Claim 8 or Claim 9, wherein the removable display device (2) includes a ventilation intake (500) equipped with a filtration system in order to retain oil vapours, greasy materials and other particles.

11. Dynamic display system as claimed in any one of Claims 4 to 10, wherein the frontal location (100) of the housing (1, 1', 1", 1"') has a volume which is determined in order to contain the rear part of the removable device (2), the projective cover (23) including a metallic material have reflective properties, the housing comprising an opening frame (13) with a window which is removable or articulated so that it can be folded back over the front opening (10).

12. Dynamic display system as claimed in any one of Claims 1 to 11, wherein the removable device (2) comprises a reader (29) for digital data media disks.

13. Dynamic display system as claimed in Claim 12, wherein the reader (29) is arranged so as to be directly accessible via an entry hatch situated outside the frontal location.

14. Dynamic display system as claimed in any one of Claims 6 to 13, wherein the display screen (200) of the removable device (2) has defined dimensions substantially equal to the dimensions of the front opening (10), adaptation means being provided in the video control module (25) of the screen in order to adapt digital data representing the video and/or animation to the format of the display screen (200).

15. Dynamic display system as claimed in any one of Claims 1 to 14, wherein the support means (16) of the poster frames (3) consist of retaining profiles disposed on the periphery of the front opening (10) and suitable for fixing on complementary profiles located on the periphery of the poster frames (3) and of the removable device (2) respectively.

16. Dynamic display system as claimed in any one of Claims 6 to 15, wherein the removable digitally controlled display device (2) comprises user interface means connected by a physical and/or remote connection to the processing unit (26) in order to enable control of the display on the screen (200) by use of programming software stored in the storage means (27).

17. Dynamic display system as claimed in any one of Claims 7 to 16, wherein the removable digitally controlled display device (2) is controlled remotely by a programming server which is connected to the network and has sources of information for remote transmission, these information sources including digital data in particular, the said programming server controlling equipment for remote maintenance of the said device (2).

18. A dynamic display system as claimed in any one of Claims 1 to 17, in which the housing (1, 1', 1", 1'") is substantially of trapezoidal shape, the housing comprising a horizontal top and bottom, the back of the housing being substantially vertical, the front opening (10) for the removable digitally controlled display device (2) being inclined at an angle of between 0 and 30°, the maximum thickness of the housing remaining below 30 cm and having a minimum thickness of the order of 10 cm, the lighting system comprising lighting means distributed over the height of the housing.

19. Dynamic display system as claimed in any one of Claims 1 to 16, wherein air flow channelling partitions (52) are provided in the rear part in order to delimit at least one restricted zone of forced ventilation aground electronic components.

20. Removable digitally controlled display device (2) intended to replace at least one poster frame (3) in a box or housing (1, 1' 1"'; 1'") of the type having a back-lit display and provided with at least one support means (16) for supporting at least one removable poster frame (3) and at least one front opening (10) with frontal location (100) of defined dimensions, the device (2) being **characterised in that** it includes an electrical and mechanical interface in order to establish in a detachable manner both a connection to an electrical power supply situated in the housing (1, 1', 1"; 1'") and fixing of the device (2) in the frontal location (100), a front part formed by a frame (20) and a flat display screen (200) mounted in the frame (20), and a rear control and management part fixed to the back of the front part.

21. Removable display device (2) as claimed in Claim 20, wherein the display screen (200) is mounted in a frame (20) of which the shape and dimensions correspond to those of an associated poster frame (3), fixing means attached to the frame (20) being provided in order to retain the viewing screen in a frontal position.

22. Removable display device (2) as claimed in Claims 20 or Claim 21, wherein the rear part of the removable digitally controlled display device (2) includes a cover (23) for protection against optical and electromagnetic radiation.

23. Removable display device (2) as claimed in any one of Claims 20 to 22, wherein the rear part of the removable device has a format with dimensions less than or equal to the format of the frame (20) of the front part, the rear part including electronic management and control components fixed by attachment means and distributed over the back of the display screen (200) constituting the front part, all of the electronic components being disposed in a flattened volume of suitable shape delimited by a protective cover of which the thickness is between 2 and 10 cm.

24. Removable display device (2) as claimed in any one of Claims 20 to 23, wherein the rear part of the screen (200) includes in particular:
- a video control module (25) for the flat screen (200),
- graphics card means with or without a sound card,
- a professing unit (26) for the execution of software modules and in particular the management of multimedia functions on the flat screen (200),
- storage means (27) for storing data representing images and audiovisual/digital animations.

25. Removable display device (2) as claimed in any one of Claims 20 to 24, including means for communication and connection to a network in order to transmit and to receive in particular data of the digital audiovisual type via at least one two-way channel.

26. Removable display device (2) as claimed in any one of Claims 20 to 25, including a ventilation intake (500) equipped with a filtration system in order to retain oil vapours, greasy materials and other particules.

27. Removable display device (2) as claimed in any one of Claims 23 to 26, including means for removal of air heated by the electronic management and control components and the display components.

28. Removable display device (2) as claimed in any one of Claims 23 to 26, **characterised in that** it is of the type without a ventilation opening and includes a radial ventilation assembly (520) provided for mixing the air heated by the electronic management and control components and for ensuing transmission of heat through the protective cover (23), the said cover (23) being based on a metal adapted for transmission of the heat by convection and radiation.

29. Removable display device (2) as claimed in any one of Claims 20 to 26, wherein the said rear part is provided with at least one fan (521) disposed tangentially in order to provide an ascending air circulation, at least one ventilation intake (522) being provided at the front of the device (2) below the display screen (200) and a discharge outlet (523) at the rear of the device (2).

30. Removable display device (2) as claimed in any one of Claims 24 to 29, wherein the display screen (200) has defined dimensions substantially equal to the dimensions of the front opening (10), adaptation means being provided in the video control module (25) of the screen in order to adapt digital data representing the video and/or animation to the format of the display scree (200).

31. Removable display device (2) as claimed in any one of Claims 25 to 30, including remote maintenance equipment which can be controlled remotely by a programming server which is connected to the network and has sources of information for remote transmission, these information sources including digital data in particular.

32. Removable display device (2) as claimed in any one of Claims 20 to 31, wherein the removable device (2) comprises a reader (29) for digital data media disks.

33. Removable display device (2) as claimed in Claims 32, wherein the reader (29) is arranged so as to be directly accessible via an entry hatch situated outside the frontal location.

## Patentansprüche

1. Dynamisches Anzeigesystem, aufweisend ein Gehäuse (1, 1', 1", 1"'), das mit mindestens einer Stirnseitenöffnung (10) und mindestens einem Stützmittel (16) in dem Gehäuse (1, 1', 1", 1"') zum Tragen mindestens eines herausnehmbaren Anzeigerahmens (3) versehen ist, wobei ein Beleuchtungssystem (4) zum Bereitstellen einer Hintergrundbeleuchtung der Anzeigen (3) in dem Gehäuse (1, 1', 1", 1'") verteilt ist, **dadurch gekennzeichnet, dass** mindestens eine herausnehmbare Anzeigevorrichtung (2) mit Digitalsteuerung im Austausch gegen mindestens einen Anzeigerahmen (3) zum Abdecken der Stirnseitenöffnung oder der Stirnseitenöffnungen (10) vorgesehen ist, wobei die herausnehmbare Vorrichtung (2) einen aus einem Rahmen (20) und einem in dem Rahmen (20) montierten flachen Anzeigebildschirm (200) gebildeten sogenannten vorderen Teil und einen an der Rückseite des vorderen Teils befestigten, hinteren Steuerungs- und Verwaltungsteil aufweist, wobei eine elektrische und mechanische Schnittstelle an der herausnehmbaren Vorrichtung (2) vorgesehen ist, um gleichzeitig lösbar eine Verbindung mit einer in dem Gehäuse (1, 1', 1", 1"') angeordneten Stromversorgungsquelle und eine Befestigung der Vorrichtung an einer Stirnseitenposition (100) des Gehäuses (1, 1', 1", 1''') herzustellen.

2. Dynamisches Anzeigesystem gemäß Anspruch 1, wobei der Anzeigebildschirm (200) in einem Rahmen (20) montiert ist, dessen Form und Abmessungen mit einem zugeordneten Anzeigerahmen (3) korrespondieren, wobei mit dem Rahmen (20) einstückige Befestigungsmittel vorgesehen sind, um den Anzeigebildschirm (200) in einer Stirnseitenposition zu halten.

3. Dynamisches Anzeigesystem gemäß Anspruch 1 oder 2, wobei die herausnehmbare Vorrichtung (2) derart bemessen ist, dass sie gegen einen durch die stirnseitenöffnung (10) hindurch dargestellten Anzeigerahmen (3) austauschbar ist, wobei die Stützmittel (16) für den Anzeigerahmen (3) eingerichtet sind, um an Mitteln zum schnellen Befestigen der herausnehmbaren Vorrichtung (2) angebracht zu werden.

4. Dynamisches Anzeigesystem gemäß einem der Ansprüche 1 bis 3, wobei das Beleuchtungssystem (4) mindestens eine Leuchtstoffröhre aufweist, wobei der hintere Teil der herausnehmbaren Anzeigevorrichtung (2) mit Digitalsteuerung eine Abdeckung (23) zum Schutz gegen optische und elektromagnetische Strahlung aufweist.

5. Dynamisches Anzeigesystem gemäß einem der Ansprüche 1 bis 4, wobei der hintere Teil der herausnehmbaren Vorrichtung (2) ein Format mit Abmessungen aufweist, die kleiner oder gleich dem Format des Rahmens (20) des vorderen Teils sind, wobei der hintere Teil elektronische Verwaltungs- und Steuerungskomponenten aufweist, die mittels Befestigungsmitteln befestigt und auf der Rückseite des den vorderen Teil bildenden Anzeigebildschirms (200) verteilt sind, wobei die Gesamtheit der elektronischen Komponenten in einem abgeflachten Volumen mit angepasster Form angeordnet ist, das von einer Schutzabdeckung (23) begrenzt wird, deren Dicke zwischen 2 cm und 10 cm liegt.

6. Dynamisches Anzeigesystem gemäß einem der Ansprüche 1 bis 5, wobei der hintere Teil des Bildschirms (200) insbesondere aufweist:
- ein Modul zur Videosteuerung (25) des Flachbildschirms (200),
- Grafikkartenmittel mit oder ohne Soundkarte,
- eine Verarbeitungseinheit (26) zum Ausführen von Softwaremodulen und insbesondere zum Verwalten von Multimediafunktionen des Flachbildschirms (200), und
- Speichermittel (27) zum Speichern von für Bilder und Audio-Video-/digitale Animationen repräsentativen Daten.

7. Dynamisches Anzeigesystem gemäß einem der Ansprüche 1 bis 6, wobei die herausnehmbare Vorrichtung (2) Mittel zum Kommunizieren und Verbinden (22) mit einem Netzwerk zum Senden und Empfangen insbesondere von digitalen Daten des Audio-Video-Typs mittels mindestens eines Bidirektionalkanals aufweist.

8. Dynamisches Anzeigesystem gemäß einem der Ansprüche 5 bis 7, wobei die herausnehmbare Anzeigevorrichtung (2) mit Digitalsteuerung Mittel zum Ableiten der durch die elektronischen Verwaltungs- und Steuerkomponenten und die Anzeigekomponenten erwärmten Luft aufweist.

9. Dynamisches Anzeigesystem gemäß einem der Ansprüche 5 bis 8, wobei der hintere Teil mindestens ein Kühlsystem aufweist, das zum Ableiten der von mindestens einer der elektronischen Verwaltungs- und Steuerkomponenten abgegebenen Wärme angeordnet ist.

10. Dynamisches Anzeigesystem gemäß Anspruch 8 oder 9, wobei die herausnehmbare Anzeigevorrichtung (2) einen Belüftungseingang (500) aufweist, der mit einem Filtersystem versehen ist, um Öldämpfe, Fettstoffe und andere Teilchen zurückzuhalten.

11. Dynamisches Anzeigesystem gemäß einem der Ansprüche 4 bis 10, wobei die Stirnseitenposition (100) des Gehäuses (1, 1', 1", 1"') ein bestimmtes Volumen zum Aufnehmen des hinteren Teils der herausnehmbaren Vorrichtung (2) aufweist, wobei die Schutzabdeckung (23) ein Metallmaterial mit reflektierenden Eigenschaften aufweist, wobei das Gehäuse einen Öffnungsrahmen (13) mit Fenster aufweist, der herausnehmbar oder gelenkig gelagert ist, um an der Stirnseitenöffnung (10) heruntergeklappt zu werden.

12. Dynamisches Anzeigesystem gemäß einem der Ansprüche 1 bis 11, wobei die herausnehmbare Vorrichtung (2) einen Leser (29) für Digitaldatenträger-Disks aufweist.

13. Dynamisches Anzeigesystem gemäß Anspruch 12, wobei der Leser (29) derart eingerichtet ist, dass er über eine Einführklappe zugänglich ist, die an der Außenseite der Stirnseitenposition angeordnet ist.

14. Dynamisches Anzeigesystem gemäß einem der Ansprüche 6 bis 13, wobei der Anzeigebildschirm (200) der herausnehmbaren Vorrichtung (2) bestimmte Abmessungen aufweist, die im Wesentlichen gleich den Abmessungen der Stirnseitenöffnung (10) sind, wobei Anpassungsmittel in dem Video-Steuermodul (25) des Bildschirms vorgesehen sind, um für Video und/oder Animationen repräsentative digitale Daten an das Format des Anzeigebildschirms (200) anzupassen.

15. Dynamisches Anzeigesystem gemäß einem der Ansprüche 1 bis 14, wobei die Mittel zum Stützen (16) von Anzeigerahmen (3) aus Halteprofilen bestehen, die am Rand der Stirnseitenöffnung (10) angeordnet sind und dazu geeignet sind, an komplementären Profilen befestigt zu werden, die jeweils am Umfang der Anseigerahmen (3) und der herausnehmbaren Vorrichtung (2) positioniert sind.

16. Dynamisches Anzeigesystem gemäß einem der Ansprüche 6 bis 15, wobei die herausnehmbare Anzeigevorrichtung (2) mit Digitalsteuerung Benutzerschnittstellenmittel aufweist, die über eine physikalische Verbindung und/oder über eine Fernverbindung mit der Verarbeitungseinheit (26) verbunden sind, um eine Steuerung der Anzeige auf dem Bildschirm (200) mittels einer Programmsoftware zu ermöglichen, die in den Speichermitteln (27) gespeichert ist.

17. Dynamisches Anzeigesystem gemäß einem der Ansprüche 7 bis 16, wobei die herausnehmbare Anzeigevorrichtung (2) mit Digitalsteuerung mittels eines Programmierservers ferngesteuert wird, der mit dem Netzwerk verbunden ist und Fernübertragungsinformationsquellen aufweist, wobei die Informationsquellen insbesondere digitale Daten aufweisen, wobei der Programmierserver eine Fernwartungseinrichtung der Vorrichtung (2) steuert.

18. Dynamisches Anzeigesystem gemäß einem der Ansprüche 1 bis 17, wobei das Gehäuse (1, 1', 1", 1"') im Wesentlichen trapezförmig ist, wobei das Gehäuse ein horizontales oberes und ein horizontales unteres Ende aufweist, wobei der Boden des Gehäuses im Wesentlichen vertikal ist, wobei die Stirnseitenöffnung (10) für die herausnehmbare Anzeigevorrichtung (2) mit Digitalsteuerung um einen Winkel zwischen 0° und 30° geneigt ist, wobei die maximale Dicke des Gehäuses kleiner als 30 cm bleibt und das Gehäuse eine minimale Dicke in der Größenordnung von 10 cm aufweist, wobei das Beleuchtungssystem (4) über die Höhe des Gehäuses verteilte Beleuchtungsmittel aufweist.

19. Dynamisches Anzeigesystem gemäß einem der Ansprüche 1 bis 18, wobei Trennwände zum Kanalisieren des Luftstroms (52) in dem hinteren Teil vorgesehen sind, um zumindest einen begrenzten Zwangsbelüftungsbereich um elektronische Komponenten herum zu begrenzen.

20. Dynamisches Anzeigesystem (2) mit Digitalsteuerung, das zum Austauschen mindestens eines Anzeigerahmens (3) in einem Kasten oder Gehäuse (1, 1', 1", 1"') des Typs mit Anzeigen-Hintergrundbeleuchtung vorgesehen ist und mit mindestens einem Stützmittel (16) zum Halten mindestens eines herausnehmbaren Anzeigerahmens (3) und mindestens einer Stirnseitenöffnung (10) mit Stirnseitenposition (100) mit bestimmten Abmessungen versehen ist, wobei die Vorrichtung (2) **dadurch gekennzeichnet ist, dass** sie aufweist: eine elektrische und mechanische Schnittstelle, um gleichzeitig lösbar eine Verbindung mit einer in dem Gehäuse (1, 1', 1", 1"') angeordneten Stromversorgungsquelle und eine Befestigung der Vorrichtung (2) an der Stirnseitenposition (100) herzustellen, einen sogenannten vorderen Teil, der von einem Rahmen (20) und einem in dem Rahmen (20) montierten flachen Anzeigebildschirm (200) ausgebildet ist, und einen hinteren Steuerungs- und Verwaltungsteil, der an der Rückseite des vorderen Teils befestigt ist.

21. Herausnehmbare Anzeigevorrichtung (2) gemäß Anspruch 20, wobei der Anzeigebildschirm (200) in einem Rahmen (20) montiert ist, dessen Form und Abmessungen mit einem zugeordneten Anzeigerahmen (3) korrespondieren, wobei mit dem Rahmen (20) einstückige Befestigungsmittel vorgesehen sind, um den Anzeigebildschirm (200) in der Stirnseitenposition zu halten.

22. Herausnehmbare Anzeigevorrichtung (2) gemäß Anspruch 20 oder 21, wobei der hintere Teil der herausnehmbaren Anzeigevorrichtung (2) mit Digitalsteuerung eine Abdeckung (23) zum Schutz gegen optische und elektromagnetische Strahlung aufweist.

23. Herausnehmbare Anzeigevorrichtung (2) gemäß einem der Ansprüche 20 bis 22, wobei der hintere Teil der herausnehmbaren Vorrichtung (2) ein Format mit Abmessungen aufweist, die kleiner oder gleich dem Format des Rahmens (20) des vorderen Teils sind, wobei der hintere Teil elektronische Verwaltungs- und Steuerkomponenten aufweist, die mittels Befestigungsmitteln angebracht und auf der Rückseite des den vorderen Teil bildenden Anzeigebildschirms (200) verteilt sind, wobei die Gesamtheit der elektronischen Komponenten in einem abgeflachten Volumen mit einer angepassten Form angeordnet ist, das von einer Schutzabdeckung (23) begrenzt wird, deren Dicke zwischen 2 cm und 10 cm liegt.

24. Herausnehmbare Anzeigevorrichtung (2) gemäß einem der Ansprüche 20 bis 23, wobei der hintere Teil des Bildschirms (200) insbesondere aufweist:
- ein Modul zur Videosteuerung (25) des Flachbildschirms (200),
- Grafikkarten- und Soundkartenmittel,
- eine Verarbeitungseinheit (26) zum Ausführen von Softwaremodulen und insbesondere zum Verwalten von Multimediafunktionen des Flachbildschirms (200), und
- Speichermittel (27) zum Speichern von für Bilder und Audio-Video-/digitale Animationen repräsentativen Daten.

25. Herausnehmbare Anzeigevorrichtung (2) gemäß einem der Ansprüche 20 bis 24, aufweisend Mittel zum Kommunizieren und Verbinden (22) mit einem Netzwerk zum Senden und Empfangen insbesondere von digitalen Daten des Audio-Video-Typs mittels mindestens eines Bidirektionalkanals.

26. Herausnehmbare Anzeigevorrichtung (2) gemäß einem der Ansprüche 20 bis 25, aufweisend einen Belüftungseingang (500), der mit einem Filtersystem versehen ist, um Öldämpfe, Fettstoffe und anderen Teilchen (Rauch, und so weiter) zurückzuhalten.

27. Herausnehmbare Anzeigevorrichtung (2) gemäß einem der Ansprüche 23 bis 26, aufweisend Mittel zum Ableiten der von den elektronischen Verwaltungs- und Steuerkomponenten und den Anzeigekomponenten erwärmten Luft.

28. Herausnehmbare Anzeigevorrichtung (2) gemäß einem der Ansprüche 23 bis 26, **dadurch gekennzeichnet, dass** sie vom Typ ohne Belüftungsöffnung ist und einen Radialbelüftungssatz (520) aufweist, der vorgesehen ist, um die von den elektronischen Verwaltungs- und Steuerkomponenten erwärmte Luft umzuwälzen und eine Wärmeübertragung durch die Schutzabdeckung (23) hindurch sicherzustellen, wobei die Abdeckung (23) auf Basis eines Metalls ist, das angepasst ist, um Wärme mittels Konvektion und Strahlung zu übertragen.

29. Herausnehmbare Anzeigevorrichtung (2) gemäß einem der Ansprüche 20 bis 26, wobei der hintere Teil ausgestattet ist mit mindestens einem Lüfter (521), der tangential angeordnet ist, um eine aufsteigende Luftzirkulation zu erzeugen, mindestens einem Belüftungseingang (522), der an der Vorderseite der Vorrichtung (2) unter dem Anzeigebildschirm (200) vorgesehen ist, und einem Ableitungsausgang (523) an der Rückseite der Vorrichtung (2).

30. Herausnehmbare Anzeigevorrichtung (2) gemäß einem der Ansprüche 24 bis 29, wobei der Anseigebildschirm (200) bestimmte Abmessungen aufweist, die im Wesentlichen gleich den Abmessungen der Stirnseitenöffnung (10) sind, wobei in dem Videosteuermodul (25) des Bildschirms Anpassungsmittel vorgesehen sind, um für Video und/oder Animationen repräsentative digitale Daten an das Format des Anzeigebildschirms (200) anzupassen.

31. Herausnehmbare Anzeigevorrichtung (2) gemäß einem der Ansprüche 25 bis 30, aufweisend eine Fernwartungseinrichtung, die über einen Programmierserver fernsteuerbar ist, der mit dem Netz verbunden ist und Fernübertragungs informations quellen aufweist, wobei die Informations quellen insbesondere digitale Daten aufweisen.

32. Herausnehmbare Anzeigevorrichtung (2) gemäß einem der Ansprüche 20 bis 31, wobei die herausnehmbare Vorrichtung (2) einen Leser (29) für Digitaldatenträger-Disks aufweist.

33. Herausnehmbare Vorrichtung gemäß Anspruch 32, wobei der Leser (29) derart vorgesehen ist, dass er direkt über eine Einführklappe zugänglich ist, die an der Außenseite der Stirnseitenstelle angeordnet ist.
